# EUROPÄISCHE PATENTANMELDUNG

(11) **EP 1 574 975 A1**
(43) Veröffentlichungstag der Anmeldung: **14.09.2005**
(21) Anmeldenummer: 04005449.6
(22) Anmeldetag: 08.03.2004
(51) Int. Cl.: G06F 17/50, G06T 17/00

(54) **System und Verfahren zum Auslagern von Konstruktionsdaten aus einer mit einem Softwareprogramm zum Computergestützten Konstruieren erstellten Bauteildatei**

(71) Anmelder: Intec Industrie-Technik GmbH & Co. KG, 83623 Dietramszell-Lochen (DE)
(72) Erfinder: von Bechtolsheim, Eberhard, 83661 Lenggries (DE); Franz, Ralf, 85435 Erding (DE)
(74) Vertreter: von Hellfeld, Axel

(57) **Zusammenfassung**

Es wird ein Verfahren zum Auslagern von Konstruktionsdaten aus einer mit einem Softwareprogramm zum computergestützten Konstruieren erstellten ersten Bauteildatei vorgeschlagen. Das Softwareprogramm unterstützt Bauteildateien und Produktdateien, wobei Bauteildateien zur Ablage von Informationen über das Zusammenspiel mehrerer zu einer Baugruppe zusammengefasster Bauteile oder/und Unterbaugruppen dienen. Die Konstruktionsdateien repräsentieren ein erstes Bauteil eines zumindest dieses erste Bauteil umfassenden Konstruktionsgebildes. Das Verfahren umfasst die folgenden Schritte:
- Prüfen, ob das erste Bauteil geometrisch von mindestens einer Eingangsvariable abhängt, deren Wert die erste Bauteildatei durch dateiübergreifende Verknüpfung von einer Quelldatei bezieht,
- falls bei der Prüfung festgestellt wird, dass das erste Bauteil von mindestens einer Eingangsvariable abhängt, Aufheben der Verknüpfung der ersten Bauteildatei mit der Quelldatei jeder Eingangsvariable des ersten Bauteils,
- Duplizieren von das erste Bauteil beschreibenden Dateiinhalten der ersten Bauteildatei und Einfügen der duplizierten Dateiinhalte in eine zweite Bauteildatei. Die Erfindung ermöglicht die Implementierung eines CAD-Softwaresystems, welches verschiedene Dateiformate unterstützt, beispielsweise CATIA V5, in üblichen oder in Anwendung befindlichen PDM-Systemen.

## Beschreibung

Die Erfindung betrifft allgemein das Gebiet des computerunterstützten Entwerfens von Konstruktionsgebilden, beispielsweise für den Kraftfahrzeugbau oder den Flugzeugbau. Insbesondere befasst sich die Erfindung mit dem Auslagern von Konstruktionsdaten in einer Programmumgebung eines Softwareprogramms zum computergestützten Konstruieren.

Die Entwicklung und Konstruktion von komplexen Systemen bedingt eine gegenseitige Beeinflussung von Bauteilen und Baugruppen zueinander. Solche komplexen Systeme, beispielsweise Fahrzeuge, werden heute oftmals von mehreren Entwicklungsingenieuren oder Ingenieursteams entwickelt, die parallel an verschiedenen Komponenten des Systems arbeiten (Simultaneous Engineering oder Concurrent Engineering). Dabei ist es wichtig, dass zu jedem Zeitpunkt alle Bauteile und Baugruppen des Systems zusammengeführt werden können. Da der Entwicklungsprozess auf verschiedene Orte verteilt stattfindet, ist ein reibungsloser Datenaustausch zwischen den verschiedenen Beteiligten unumgänglich. Der Datenaustausch kann sowohl zwischen Beteiligten eines Unternehmens als auch unternehmensübergreifend erforderlich sein.

Um den Datenaustausch zuverlässig gestalten zu können, ist eine strukturierte Ablage aller produktrelevanten Daten wichtig. Als Drehscheibe für die Datenverwaltung kommen sogenannte Produktdatenverwaltungssysteme (Product Data Management Systems; PDM-Systeme) zum Einsatz. Sie erlauben eine saubere und eindeutige Dokumentation des Entwicklungsprozesses, indem sie alle entwicklungsrelevanten Daten und Dateien archivieren. Anhand von Versionen einer Datei können so beispielsweise Änderungen dokumentiert werden, die ein Produkt während seines Entwicklungsprozesses durchläuft. Hierdurch ist ein Vergleich unterschiedlicher Bearbeitungszustände desselben Bauteils während des Entwicklungsprozesses möglich.

Software für das computergestützte Entwerfen ("computer-aided design"; CAD) ist weithin verfügbar. Ein Beispiel einer solchen Software ist CATIA V5. Unter dieser Bezeichnung wird von Dassault Systemes ein CAD-Softwareprogramm am Markt angeboten, das ein objektorientiertes Entwerfen von dreidimensionalen geometrischen Systemen erlaubt. CATIA V5 benützt zur digitalen Abbildung solcher Systeme zwei unterschiedliche Dateiformate, nämlich Dateien vom Typ CATPart und Dateien vom Typ CATProduct. Diese zwei verschiedenen Dateiformate sorgen für eine Trennung zwischen der geometrischen Information eines Bauteils und der Information über die gegenseitige geometrische Beziehung verschiedener Bauteile oder/und Baugruppen. CATProdukt-Dateien enthalten auch Informationen über etwaige Mehrfachverwendungen von Norm- und/oder Gleichteilen innerhalb Baugruppen eines aktiven Dokuments.

In CATPart-Dateien wird die konstruktive (geometrische) Information von Bauteilen abgelegt. Ein Bauteil kann in CATIA V5 durch körperbildende Geometrie (sogenannte "solids") oder/und durch Draht- oder Flächengeometrie (nicht-körperbildende Geometrie), die man auch als Hilfsgeometrie bezeichnen kann, dargestellt werden. Dateien, in denen die Geometrie eines Bauteils abgelegt wird, werden hier als Bauteildateien bezeichnet.

CATProduct-Dateien enthalten übergeordnete Informationen, die insbesondere das Zusammenspiel verschiedener Bauteile oder auch Baugruppen bestimmen. Geometrische Information einzelner Bauteile ist in CATProduct-Dateien nicht enthalten. Erst anhand der Information in einer oder mehreren CATProduct-Dateien kann aber ein aus verschiedenen Bauteilen, die jeweils durch eine CATPart-Datei repräsentiert sind, bestehendes Konstrukt zusammengesetzt werden. Dateien, die dazu dienen, Informationen über die gegenseitigen Beziehungen der Bauteile oder/und Baugruppen aufzunehmen, werden hier als Produktdateien bezeichnet. In solchen Produktdateien ist auch der Dateipfad jedes verwendeten Bauteils und jeder verwendeten Baugruppe protokolliert und dauerhaft gespeichert.

CATIA V5 ermöglicht eine assoziative Verknüpfung von Bauteilen. Im Rahmen einer assoziativen Verknüpfung kann eine nehmende Bauteildatei (Kind; engl.: child) den Wert einer oder mehrerer Variablen von einer gebenden Bauteildatei (Eltern; engl.: parent) beziehen. Diese Variable kann als Schnittstelle zwischen den beiden Bauteildateien betrachtet werden. Eine Eltern-Kind-Verknüpfung gilt auch für jedes assoziative Element einer Bauteildatei. Als Variablen kommen in CATIA V5 geometrische Objekte, wie beispielsweise Punkte, Linien oder Flächen, sowie Parameter für numerische Größen in Frage.

Weitere Informationen zu CATIA V5 können den folgenden Buchveröffentlichungen entnommen werden:
Rudolf W. Rembold: *"Einstieg in CATIA V5*", Carl Hanser Verlag München Wien, 2. Auflage, 2004
Michael Trzesniowski: "*CAD mit CATIA V5*", Friedr. Vieweg & Sohn Verlag, 2. Auflage, 2003

Für nähere Erläuterungen zu CATIA V5 wird hiermit ausdrücklich und vollinhaltlich auf diese Buchveröffentlichungen Bezug genommen.

Bisherige marktübliche oder in Anwendung befindliche PDM-Systeme verlangen ein einheitliches Dateiformat zur Speicherung der Konstruktionsdaten eines mit einem CAD-Programm entwickelten Konstruktionsgebildes. Aufgrund der unterschiedlichen Dateitypen eignet sich CATIA V5 nicht zur Anbindung an bestehende PDM-Systeme. Daher ist auch der unternehmensinterne und -externe Austausch von mit CATIA V5 erstellten Konstruktionsdaten, wenn überhaupt, nur mit großen Schwierigkeiten möglich. Auch die eindeutige Dokumentation des Entwicklungsprozesses leidet entsprechend.

Aufgabe der Erfindung ist es, einen Weg aufzuzeigen, wie der Austausch von Konstruktionsdaten erleichtert werden kann, die mit einem CAD-Programm gewonnen werden, welches verschiedene Dateiformate zur Speicherung von Bauteilinformationen und Baugruppeninformationen vorsieht.

Erfindungsgemäß ist zur Lösung dieser Aufgabe ein computer-implementiertes System zum Auslagern von Konstruktionsdaten eines ersten Bauteils aus einer mit einem Softwareprogramm zum computergestützten Konstruieren erstellten ersten Bauteildatei vorgesehen, wobei das Softwareprogramm Bauteildateien und Produktdateien unterstützt, wobei Bauteildateien zur Ablage von Informationen über die Geometrie einzelner Bauteile dienen und Produktdateien zur Ablage von Informationen über das Zusammenspiel mehrerer zu einer Baugruppe zusammengefasster Bauteile oder/und Unterbaugruppen dienen, wobei das System dazu ausgebildet ist, in Antwort auf ein durch eine benutzerseitige Eingabeoperation erzeugtes Steuersignal die folgenden Schritte programmgesteuert durchzuführen:
- Prüfen, ob das erste Bauteil geometrisch von mindestens einer Eingangsvariable abhängt, deren Wert die erste Bauteildatei durch dateiübergreifende Verknüpfung von einer Quelldatei bezieht,
- falls bei der Prüfung festgestellt wird, dass das erste Bauteil von mindestens einer Eingangsvariable abhängt, Aufheben der Verknüpfung der ersten Bauteildatei mit der Quelldatei jeder Eingangsvariable des ersten Bauteils,
- Duplizieren von das erste Bauteil beschreibenden Dateiinhalten der ersten Bauteildatei und Einfügen der duplizierten Dateiinhalte in eine zweite Bauteildatei.

Außerdem ist erfindungsgemäß ein Verfahren zum Auslagern von Konstruktionsdaten eines ersten Bauteils aus einer mit einem Softwareprogramm zum computergestützten Konstruieren erstellten ersten Bauteildatei vorgesehen, wobei das Softwareprogramm Bauteildateien und Produktdateien unterstützt, wobei Bauteildateien zur Ablage von Informationen über die Geometrie einzelner Bauteile dienen und Produktdateien zur Ablage von Informationen über das Zusammenspiel mehrerer zu einer Baugruppe zusammengefasster Bauteile oder/und Unterbaugruppen dienen, wobei das Verfahren die Schritte umfasst:
- Prüfen, ob das erste Bauteil geometrisch von mindestens einer Eingangsvariable abhängt, deren Wert die erste Bauteildatei durch dateiübergreifende Verknüpfung von einer Quelldatei bezieht,
- falls bei der Prüfung festgestellt wird, dass das erste Bauteil von mindestens einer Eingangsvariable abhängt, Aufheben der Verknüpfung der ersten Bauteildatei mit der Quelldatei jeder Eingangsvariable des ersten Bauteils,
- Entnehmen von das erste Bauteil beschreibenden Dateiinhalten aus der ersten Bauteildatei und Einfügen dieser Dateiinhalte in eine zweite Bauteildatei.

Es hat sich gezeigt, dass in CATIA V5 aufgrund der vielfältigen dateiübergreifenden Verknüpfungen eine in eine bestehende Produktstruktur eingebundene CATPart-Datei nicht ohne weiteres als solche kopiert werden kann, beispielsweise um die Kopie einem anderen an der Entwicklung Beteiligten zugänglich zu machen. Auch kann nicht ohne weiteres eine außerhalb der Produktstruktur gehaltene CATPart-Datei in die Produktstruktur eingefügt werden und insbesondere nicht eine darin vorhandene CATPart-Datei ersetzen, beispielsweise als neue Version eines Bauteils. In solchen Fällen kann es zu einem Verlust der eindeutigen Zuordenbarkeit zwischen CATPart-Dateien und CATProduct-Dateien kommen, was zur Folge haben kann, dass das durch die Produktstruktur repräsentierte Gesamtsystem nicht mehr vollständig, nicht korrekt oder im schlimmsten Fall überhaupt nicht mehr zusammengeführt werden kann.

Die Erfindung stellt ein Konzept bereit, das es ermöglicht, eine Kopie der Konstruktionsdaten eines Bauteils zu erstellen, welches assoziativ von einem oder mehreren anderen Bauteilen abhängt, ohne dabei einen Verlust der eindeutigen Zuordenbarkeit innerhalb einer diese Bauteile umfassenden Produktstruktur befürchten zu müssen. Die duplizierten Dateiinhalte können in einer neu eingerichteten, noch leeren Bauteildatei abgelegt werden oder in eine schon bestehende, bereits mit Inhalt gefüllte Bauteildatei eingeordnet werden.

Zunächst wird im Rahmen der Erfindung geprüft, ob eine assoziative Abhängigkeit des ersten Bauteils von einer externen Eingangsvariable vorliegt. Wird festgestellt, dass die erste Bauteildatei keine Eingangsvariablen importiert, kann unmittelbar die Duplizierung der Dateiinhalte der ersten Bauteildatei erfolgen. Wird dagegen das Vorhandensein einer Verknüpfung der ersten Bauteildatei mit der Quelldatei einer importierten Eingangsvariable festgestellt, so wird erst eine Trennung der Verknüpfung bewirkt, bevor die Duplizierung der Dateiinhalte der ersten Bauteildatei erfolgt. Die Trennung der Verknüpfung ist gleichbedeutend mit einer Aufhebung der Assoziativität der importierten Eingangsvariable(n) der ersten Bauteildatei.

In der Programmumgebung von CATIA V5 beispielsweise kann die Prüfung dadurch erfolgen, dass die erste Bauteildatei auf das Vorhandensein einer nicht leeren Datenschachtel *Externe Verweise* (engl.: *External References*) und/oder einer nicht leeren Datenschachtel *Externe Parameter* (engl.: *External Parameters*) oder Vergleichbares untersucht wird. Vergleichbar meint hier, dass von Sprache zu Sprache, von Version zu Version und auch von CAD-Software zu CAD-Software natürlich unterschiedliche Namen für diese Datenschachteln vorgesehen sein können, ohne dass sich wesentliche Unterschiede in der Funktion dieser Datenschachteln ergeben. Die Datenschachtel *Externe Verweise* dient in CATIA V5 zur Ablage importierter geometrischer Objekte, während die Datenschachtel *Externe Parameter*zur Ablage importierter Parameter dient. Genauer gesagt, wird in der betreffenden Datenschachtel eine Kopie der jeweiligen Eingangsvariable zusammen mit einem Verweis auf die Quelldatei der Eingangsvariable abgelegt. Dieser Verweis stellt eine dateiübergreifende Verknüpfung von derjenigen Bauteildatei, die die Eingangsvariable bezieht, zu der Quelldatei dar. Durch Trennen dieser Verknüpfung wird die importierte Eingangsvariable, genauer deren Kopie, isoliert. Eine Funktionalität von CATIA V5 ist es, für isolierte importierte geometrische Objekte eine Datenschachtel *Isolierte externe Verweise* (engl.: *Isolated External References*) bereitzustellen.

Nachdem etwaige importierte Eingangsvariablen der ersten Bauteildatei isoliert wurden, wird der Inhalt der ersten Bauteildatei dupliziert und der duplizierte Dateiinhalt in eine andere Bauteildatei eingefügt. Da CATIA V5 beim Import von Eingangsvariablen eine Kopie der Eingangsvariable in der importierenden Bauteildatei ablegt, kann der duplizierte Dateiinhalt der ersten Bauteildatei das erste Bauteil vollständig repräsentieren, jedoch losgelöst von dessen geometrischer Abhängigkeit von anderen Bauteilen. Auf diese Weise kann eine getreue datentechnische Kopie des ersten Bauteils erhalten werden.

Wenngleich CATIA V5 ein bevorzugtes Beispiel eines CAD-Softwareprogramms ist, bei dem die Erfindung zur Anwendung kommen kann, ist es grundsätzlich nicht ausgeschlossen, die Erfindung auch in Verbindung mit anderer CAD-Software einzusetzen, sofern diese ebenfalls verschiedene Dateiformate für die geometrische Information einzelner Bauteile einerseits und die Information über die gegenseitige Beziehung der Bauteile in einem Gesamtsystem andererseits benutzt.

Das erfindungsgemäße System kann beispielsweise auf einer graphischen Benutzeroberfläche ein Steuerelement bereitstellen, das der Benutzer mittels einer Aktivierungshilfe, etwa einem durch eine Maus oder ein Touchpad steuerbaren Zeiger (Cursor), anwählen und aktivieren kann. Das Steuerelement kann beispielsweise von einem Menüfeld in einem Kontextmenü des Softwareprogramms gebildet sein. Hat der Benutzer das Steuerelement aktiviert, kann ein das Erfindungskonzept verkörperndes Programmmodul die Prüfung der ersten Bauteildatei auf den Import etwaiger Eingangsvariablen, ggf. die Trennung der Verknüpfung der ersten Bauteildatei mit der oder den Quelldateien solcher Eingangsvariablen, die Duplizierung der relevanten Dateiinhalte der ersten Bauteildatei und die Überführung der duplizierten Dateiinhalte in die zweite Bauteildatei bewirken.

Gewünschtenfalls kann das Programmmodul dabei den Benutzer während der Abfolge dieser Schritte interaktiv zu weiteren Aktionen oder/und Eingaben auffordern. Beispielsweise kann das Programmmodul den Benutzer auffordern, einen Namen einzugeben, mit dem die zweite Bauteildatei benannt werden soll. Es kann ihn auch auffordern, einen Namen für eine oder mehrere Datenschachteln einzugeben, die in der zweiten Bauteildatei zur Ablage der duplizierten Dateiinhalte der ersten Bauteildatei dienen sollen. Auch kann das Programmmodul den Benutzer beispielsweise auffordern, eine bereits durchgeführte oder noch bevorstehende Aktion des Softwareprogramms zu bestätigen. Jedenfalls bewirkt das Programmmodul aber, dass nach benutzerseitiger Aktivierung des Steuerelements eine Kette von Programmbefehlen abgearbeitet wird, die zunächst die Prüfung der ersten Bauteildatei, dann ggf. die Isolierung der Eingangsvariable(n) und danach die Duplizierung und Auslagerung der Dateiinhalte der ersten Bauteildatei bewirken.

Der Begriff Datenschachtel bezieht sich hier auf eine organisatorische Untereinheit einer Bauteildatei. Mittels solcher Datenschachteln, die man auch als Schubladen oder Ordner bezeichnen kann, ist eine hierarchische Unterteilung einer Bauteildatei möglich. In CATIA V5 sind die sogenannten *Körper* (engl.: *body*) und die sogenannten *offenen Körper* (engl.: *open body*) Beispiele für Datenschachteln.

Das Softwareprogramm kann in Bauteildateien die Einrichtung von Datenschachteln eines ersten Typs, welche der Ablage körperbildender Geometrieinformation des betreffenden Bauteils dienen, und von Datenschachteln eines zweiten Typs unterstützen, welche der Ablage nicht-körperbildender Geometrieinformation des Bauteils dienen. In CATIA V5 beispielsweise stellen Körper Datenschachteln des ersten Typs dar, während offene Körper Datenschachteln des zweiten Typs bilden. Bei der Erfindung wird dann vorzugsweise der aus jeder Datenschachtel des ersten oder zweiten Typs der ersten Bauteildatei entnommene Inhalt in der zweiten Bauteildatei in eine entsprechende Datenschachtel des ersten bzw. zweiten Typs eingeordnet. Die interne Organisation der ersten Bauteildatei spiegelt sich so in der zweiten Bauteildatei wider.

Wie bereits weiter oben angedeutet, kann die Eingangsvariable ein geometrisches Objekt sein, etwa ein Punkt, eine Linie oder eine Fläche (im Unterschied zu einem Parameter). Das Softwareprogramm kann dann dazu eingerichtet sein, in einer Bauteildatei jedes geometrische Eingangsobjekt in einer gemeinsamen, für derartige geometrische Eingangsobjekte reservierten Datenschachtel des zweiten Typs abzulegen und diese reservierte Datenschachtel des zweiten Typs mit einem vorbestimmten reservierten Namen zu benennen. In CATIA V5 beispielsweise ist es der offene Körper *Externe Verweise*, der für importierte geometrische Objekte reserviert ist. Den Namen dieses offenen Körpers kann der Benutzer in CATIA V5 nicht ändern. Er ist programmintern vorgegeben.

Richtet der Benutzer in CATIA V5 dagegen einen neuen offenen Körper ein, so wird dieser zunächst standardmäßig mit dem einheitlichen Namensbestandteil "Offener Körper" oder "Geöffneter Körper" (engl.: "Open body") oder Vergleichbarem versehen. Der Benutzer kann dann nach eigenem Wunsch diesem neuen offenen Körper einen anderen Namen geben, jedoch nur insoweit, als es sich dabei nicht um einen reservierten Namen handelt. Reservierte Namen sind in CATIA V5 z.B. "Externe Verweise" oder "Isolierte externe Verweise" oder Entsprechendes.

Im Rahmen einer bevorzugten Weiterbildung der Erfindung erfolgt nun eine Benennung derjenigen Datenschachtel des zweiten Typs der zweiten Bauteildatei, in die diejenigen geometrischen Eingangsobjekte des ersten Bauteils eingeordnet werden, welche zuvor in der ersten Beuteildatei isoliert wurden, mit einem den standardmäßig vorgegebenen Namensbestandteil nicht enthaltenden Namen. In CATIA V5 beispielsweise würde nämlich diejenige Datenschachtel der zweiten Bauteildatei, in die nach dem Duplizieren die isolierten geometrischen Eingangsobjekte einsortiert werden, ohne weitere Vorkehrungen standardmäßig mit dem Namensbestandteil "Offener Körper" oder Vergleichbarem versehen werden. Um Klarheit und Übersichtlichkeit in die zweite Bauteildatei zu bringen, ist es deshalb sinnvoll, diesen offenen Körper anders zu benennen, und zwar so, dass der Benutzer sofort vom (geänderten) Namen dieses offenen Körpers auf dessen Inhalt (die geometrischen Eingangsobjekte) schließen kann.

Es kann hierzu ein Programmmodul vorgesehen sein, das selbsttätig einen vorbestimmten Namen vergibt, beispielsweise "Eingabe" oder "Input", und die betreffende Datenschachtel automatisch so benennt. Es kann auch ein Programmmodul vorgesehen sein, das selbsttätig in Antwort auf das Auslagern der Dateiinhalte der ersten Bauteildatei in die zweite Bauteildatei eine Routine startet, in der der Benutzer interaktiv aufgefordert wird, einen Namen für die betreffende Datenschachtel z.B. über eine Tastatur einzugeben. Natürlich zieht die Erfindung auch in Betracht, dass der Benutzer von sich aus die Umbenennung veranlasst und durchführt.

Wiederum dem Ziel der Schaffung einer klaren Struktur innerhalb der zweiten Bauteildatei dient es, wenn in der zweiten Bauteildatei eine weitere Datenschachtel des zweiten Typs erzeugt wird, jede Datenschachtel des zweiten Typs, in der Inhalt aus der ersten Bauteildatei abgelegt wird, unter diese weitere Datenschachtel des zweiten Typs untergeordnet wird, und die weitere Datenschachtel des zweiten Typs mit einem auf das erste Bauteil hinweisenden Namen benannt wird. Auch dieser Vorgang kann selbsttätig und ohne gesonderte Veranlassung seitens des Benutzers unter Steuerung eines geeigneten Programmmoduls ablaufen, wobei der auf das erste Bauteil hinweisende Name beispielsweise dem Bauteilnamen der ersten Bauteildatei entnommen werden kann.

Das Softwareprogramm kann in Bauteildateien die Einrichtung von Datenschachteln eines dritten Typs, welche der Ablage von Beziehungen dienen, oder/und Datenschachteln eines vierten Typs unterstützen. In CATIA V5 beispielsweise werden dateiintern definierte (lokale) Parameter in einer Datenschachtel *Parameter*(engl.: *Parameters*) oder Vergleichbarem abgelegt, während Beziehungen, die das Zusammenspiel verschiedener geometrischer Elemente eines Bauteils regeln, in einem Ordner *Beziehungen* (engl.: *Relations*) oder einem vergleichbar benannten Ordner abgelegt werden.

Bevorzugt wird dann im Rahmen der Erfindung der aus jeder Datenschachtel des dritten oder vierten Typs der ersten Bauteildatei entnommene Inhalt in der zweiten Bauteildatei so in eine entsprechende Datenschachtel des dritten bzw. vierten Typs eingeordnet, dass sich der betreffende Inhalt in einer Datenschachtel des dritten bzw. vierten Typs der zweiten Bauteildatei befindet, welche einer weiteren Datenschachtel des dritten bzw. vierten Typs der zweiten Bauteildatei untergeordnet ist. Die untergeordnete Datenschachtel des dritten bzw. vierten Typs der zweiten Bauteildatei wird vorteilhafterweise mit einem einen Hinweis auf das erste Bauteil enthaltenden Namen benannt, um eine übersichtliche Ordnung in der zweiten Bauteildatei zu schaffen. Auch die Überführung der Parameter oder/und Beziehungen in die zweite Bauteildatei, deren Einordnung in eine untergeordnete Datenschachtel des dritten bzw. vierten Typs in der zweiten Bauteildatei sowie die entsprechende Benennung dieser Datenschachtel kann in ähnlicher Weise wie weiter oben erläutert vollautomatisch unter Steuerung eines Programmmoduls erfolgen, wobei ggf. interaktiv der Benutzer einbezogen werden kann.

Das erste Bauteil wird oftmals Teil eines Konstruktionsgebildes sein, das neben dem ersten Bauteil noch eine Reihe weiterer Bauteile enthält, wobei die Geometrie jedes dieser Bauteile in einer eigenen Bauteildatei abgelegt ist. Es kann dann der Wunsch bestehen, nicht nur die Konstruktionsdaten eines einzigen Bauteils auszulagern, beispielsweise um sie einem Dritten zugänglich zu machen, sondern die Daten mehrerer Bauteile oder ganzer Baugruppen auszulagern. Die Erfindung sieht in einer Weiterbildung vor, diese Daten in eine gemeinsame Bauteildatei auszulagern. Dann empfiehlt es sich jedoch, die Daten in der gemeinsamen Bauteildatei so zu ordnen, dass jederzeit vom Benutzer identifizierbar ist, welcher Teil der ausgelagerten Daten welchem Bauteil zugehörig ist.

Dementsprechend kann es bei Auslagerung der Konstruktionsdaten des ersten Bauteils sein, dass die zweite Bauteildatei bereits Dateiinhalte enthält, welche mindestens ein weiteres Bauteil beschreiben. Die duplizierten Dateiinhalte der ersten Bauteildatei werden dann bevorzugt in Datenschachteln der zweiten Bauteildatei eingeordnet, welche nebengeordnet zu Datenschachteln sind, in denen die das mindestens eine weitere Bauteil beschreibenden Dateiinhalte enthalten sind. Auf diese Weise können die Daten mehrerer Bauteile methodisch strukturiert in der zweiten Bauteildatei abgelegt werden.

Es kann sein, dass in einem Konstruktionsgebilde ein Bauteil den Wert einer Variable (Objekt oder Parameter) bestimmt, von der ein oder mehrere andere Bauteile geometrisch abhängen. Die betreffende Variable stellt dann sozusagen eine Ausgangsvariable dieses einen Bauteils dar. Letzteres kann auch als gebendes Bauteil bezeichnet werden, ebenso kann die Bauteildatei, die die geometrische Information des gebenden Bauteils enthält, als gebende Bauteildatei bezeichnet werden. Umgekehrt kann ein Bauteil, das von einer Ausgangsvariable eines gebenden Bauteils abhängt, als nehmendes Bauteil bezeichnet werden und die Bauteildatei des nehmenden Bauteils als nehmende Bauteildatei bezeichnet werden.

Wenn in einer gebenden Bauteildatei Informationen über die Ausgangsvariable des gebenden Bauteils enthalten sind, können diese Informationen beim Duplizieren der Dateiinhalte der gebenden Bauteildatei ebenfalls dupliziert werden und anschließend in eine andere Bauteildatei übertragen werden.

Die Informationen über die Ausgangsvariable(n) des gebenden Bauteils können dabei vom Benutzer selbst in die gebende Bauteildatei eingetragen worden sein. In CATIA V5 beispielsweise kann der Benutzer hierzu einen offenen Körper erzeugen, in dem er die betreffenden Informationen ablegt. Es kann auch sein, dass ein Programmmodul vorgesehen ist, das dazu eingerichtet ist, selbsttätig eine entsprechende Datenschachtel in der gebenden Bauteildatei zu erzeugen und mit den Informationen über die Ausgangsvariable(n) des gebenden Bauteils anzureichern, wenn Informationen über die Ausgangsvariable(n) an anderer Stelle außerhalb der gebenden Bauteildatei definiert oder verfügbar sind. In CATIA V5 beispielsweise können solche Informationen in einem Ordner (Datenschachtel) *Veröffentlichungen* (engl.: *Publications*) oder einem vergleichbaren Ordner verfügbar sein. Das Programmmodul kann dann dazu eingerichtet sein, auf die veröffentlichten Informationen eines solchen Ordners *Veröffentlichungen* zuzugreifen und basierend auf diesen Informationen in der gebenden Bauteildatei einen offenen Körper zu erzeugen und diesen mit Informationen über die Ausgangsvariable(n) des gebenden Bauteils zu füllen. Dabei kann das Programmmodul dazu eingerichtet sein, diesen offenen Körper mit einem vorbestimmten Namen zu benennen, der dem Benutzer einen unmittelbaren Hinweis über die Art der darin abgelegten Daten vermitteln kann. Beispielsweise kann das Programmmodul dem offenen Körper einen Namen geben, der den Bestandteil "Schnittstelle" oder "Output" enthält.

Dem Gedanken, ein Programmmodul vorzusehen, das dazu eingerichtet ist, in einer gebenden Bauteildatei basierend auf außerhalb dieser Bauteildatei verfügbaren Informationen über eine oder mehr Ausgangsvariable(n) eines dieser Bauteildatei zugeordneten gebenden Bauteils die Einrichtung einer solche Informationen enthaltenden Datenschachtel zu bewirken, wird im übrigen selbständig schutzfähige Bedeutung beigemessen. Die Formulierung eines entsprechenden Schutzbegehrens in Form von Verfahrens- oder/und Sachansprüchen wird ausdrücklich vorbehalten.

Es kann danach die Situation eintreten, dass in einer gemeinsamen Bauteildatei, in die Konstruktionsdaten mehrerer Bauteile nach der Methodik der Erfindung ausgelagert wurden, Informationen über eine oder mehr Eingangsvariablen eines Bauteils und ferner Informationen über eine oder mehr Ausgangsvariablen eines anderen Bauteils enthalten sind. Dabei kann es sein, dass in der ursprünglichen Produktstruktur, der die Bauteile entstammen, das eine Bauteil geometrisch von einer oder mehr Ausgangsvariablen des anderen Bauteils abhängt. Die betreffende Ausgangsvariable bildet dann eine Eingangsvariable des einen Bauteils. Dieses stellt folglich ein nehmendes Bauteil für die Ausgangsvariable dar, während das andere Bauteil gebendes Bauteil der Ausgangsvariable ist.

Entsprechend kann bei dem erfindungsgemäßen System und Verfahren nach Auslagerung der Konstruktionsdaten des ersten Bauteils die Situation eintreten, dass die zweite Bauteildatei Informationen über eine oder mehr Eingangsvariablen des ersten Bauteils und auch Informationen über eine oder mehr Ausgangsvariablen wenigstens eines weiteren Bauteils enthält. Die letzteren Informationen können zum Zeitpunkt der Einfügung der duplizierten Dateiinhalte der ersten Bauteildatei in die zweite Bauteildatei bereits in dieser enthalten sein, beispielsweise weil die Konstruktionsdaten des weiteren Bauteils schon vorher nach der erfindungsgemäßen Methodik in die zweite Bauteildatei ausgelagert wurden. Es kann aber auch sein, dass erst zu einem späteren Zeitpunkt, also nachdem die Konstruktionsdaten der ersten Bauteils schon in die zweite Bauteildatei ausgelagert wurden, die Informationen über die Ausgangsvariable(n) des weiteren Bauteils in der zweiten Bauteildatei hinzukommen.

Jedenfalls sieht eine bevorzugte Ausführungsform der Erfindung dann vor, dass der Inhalt der zweiten Bauteildatei daraufhin untersucht wird, ob eine Eingangsvariable des ersten Bauteils einer Ausgangsvariable des weiteren Bauteils entspricht. Wird eine solche Übereinstimmung zwischen einer Eingangsvariable des ersten Bauteils und einer Ausgangsvariable des weiteren Bauteils festgestellt, so wird die betreffende Ausgangsvariable mit der betreffenden Eingangsvariable innerhalb der zweiten Bauteildatei verknüpft. Auf diese Weise kann innerhalb der zweiten Bauteildatei eine assoziative Verknüpfung beider Bauteile bewirkt werden. Dies ermöglicht es, die Geometrie einer ganzen Baugruppe, die normalerweise durch mehrere Bauteildateien und eine oder mehrere Produktdateien dargestellt wird, durch eine einzige Bauteildatei abzubilden. Dies wiederum erlaubt den Einsatz herkömmlicher PDM-Systeme, die ein einheitliches Dateiformat erfordern. Der Datenaustausch innerhalb eines Unternehmens und unternehmensübergreifend wird so besonders einfach und effizient.

Die dateiinterne Verknüpfung in der zweiten Bauteildatei kann beispielsweise durch eine Operation hergestellt werden, bei der die betreffende Eingangsvariable des einen Bauteils durch die zugeordnete Ausgangsvariable des anderen Bauteils ersetzt wird ("replace"-Operation). Es wird sozusagen ein Zeiger von der Ausgangsvariable zu der Eingangsvariable erzeugt. Soll die Verknüpfung wieder gelöst werden, kann es genügen, dieselbe Operation in umgekehrter Richtung durchzuführen.

Sind Daten über mehr als zwei Bauteile in der zweiten Bauteildatei enthalten, so kann die Prüfung auf übereinstimmende Eingangs- und Ausgangsvariablen für jedes Paar von Bauteilen vorgenommen werden. Der Idee, in einer Bauteildatei, in die Konstruktionsdaten mindestens zweier Bauteile einschließlich Informationen über etwaige Eingangs- und Ausgangsvariablen der Bauteile ausgelagert wurden, eine Prüfung auf übereinstimmende Eingangs- und Ausgangsvariablen zwischen den Bauteilen vorzunehmen und bei Auffinden von Entsprechungen eine dateiinterne Verknüpfung der Variablen herzustellen, wird im übrigen selbständig schutzfähige Bedeutung beigemessen. Die Formulierung eines entsprechenden Schutzbegehrens in Form von Verfahrens- oder/und Sachansprüchen wird ausdrücklich vorbehalten.

Die Prüfung auf das Vorhandensein übereinstimmender Eingangs- und Ausgangsvariablen und ggf. die dateiinterne Verknüpfung zwischen gefundenen übereinstimmenden Eingangs- und Ausgangsvariablen in der zweiten Bauteildatei kann von einem Programmmodul selbsttätig vorgenommen werden, sobald Daten zweier Bauteile in der zweiten Bauteildatei enthalten sind. Gegebenenfalls kann der Anwender hierbei interaktiv einbezogen werden, beispielsweise indem er aufgefordert wird, eine etwaige Verknüpfungsaktion zu bestätigen. Das Programmodul kann die Prüfung und ggf. Verknüpfung jedesmal durchführen, wenn ausgelagerte Daten eines neuen Bauteils in der zweiten Bauteildatei hinzukommen.

Es versteht sich, dass das erfindungsgemäße System dazu eingerichtet sein kann, sämtliche Aspekte des vorstehend erläuterten Verfahrens voll- oder teilautomatisiert unter Steuerung eines Softwareprogramms durchzuführen, ggf. unter interaktiver Beteiligung eines Benutzers.

Die Erfindung betrifft darüber hinaus ein Computerprogrammprodukt, das einen Programmcode verkörpert, welcher dazu ausgelegt ist, bei Ausführung auf einem Computer in Antwort auf eine oder mehrere benutzerseitige Eingabeoperationen gewünschtenfalls interaktiv die Durchführung des Verfahrens der vorstehend beschriebenen Art zu bewirken. Außerdem betrifft die Erfindung ein computerlesbares Informationsträgermedium, auf dem ein solches Computerprogrammprodukt gespeichert ist. Das Informationsträgermedium kann beispielsweise eine optische oder magnetische Informationsträgerscheibe sein.

Weitere Erläuterungen zur Erfindung können der nachfolgenden Beschreibung der beigefügten Zeichnungen entnommen werden. Es stellen dar:
Figur 1 schematisch eine beispielhafte Computerumgebung, in der die Erfindung Anwendung finden kann,
Figur 2 schematisch ein beispielhaftes CAD-Konstruktionsbild einer aus drei Bauteilen zusammengesetzten Baugruppe und
Figuren 3 bis 14 beispielhafte Strukturbäume in CATIA V5, die einen gleichfalls beispielhaften manuellen Vorgang der Auslagerung von Konstruktionsdaten aus einer bestehenden Produktstruktur in eine außerhalb der Produktstruktur stehende Bauteildatei veranschaulichen.

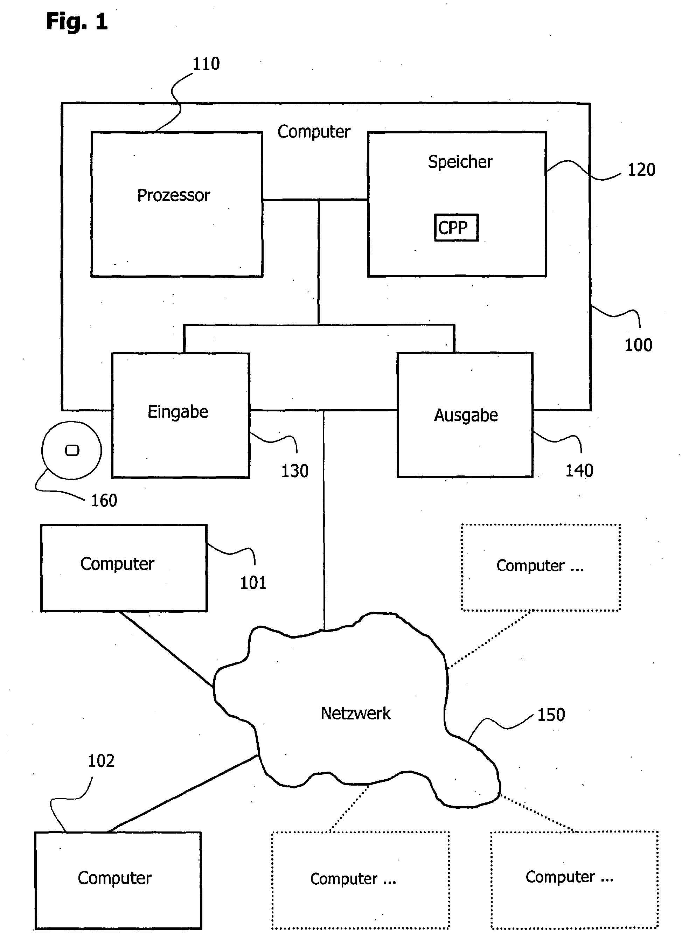

Figur 1 zeigt ein vereinfachtes Blockdiagramm eines Computersystems. Dieses umfasst einen Computer 100, welcher einen Prozessor 110, eine Speicheranordnung 120, ein oder mehr Eingabegeräte 130 und ein oder mehr Ausgabegeräte 140 enthält. Die verschiedenen Komponenten des Computers 100 arbeiten in an sich bekannter Weise zusammen. Die Eingabe- und Ausgabegeräte (E/A-Geräte) bilden eine Benutzerschnittstelle. Die Methodik der Erfindung kann in einem Computerprogrammprodukt (nachfolgend CPP genannt) verkörpert sein. Das CPP repräsentiert Programmcode, der dazu ausgelegt ist, Programmsignale zu erzeugen, die insgesamt als ein Programm bezeichnet werden. Der Programmcode steuert den Betrieb des Computers 100 und dessen Wechselwirkung mit anderen Komponenten des Computersystems.

Das Computersystem kann zusätzlich zu dem Computer 100 weitere Computer 101, 102... umfassen, die mit dem Computer 100 und miteinander über ein Netzwerk 150 verbunden sein können. Die Computer 101, 102... können gleiche oder vergleichbare Komponenten wie der Computer 100 enthalten.

Das CPP kann an beliebiger Stelle in dem Computersystem abgelegt oder auf einem gesonderten Programmträgermedium 160 vorhanden sein. Zweckmäßigerweise wird das CPP im Computer 100 hinterlegt sein, wenngleich zumindest Teile des CPP in anderen Komponenten des Netzwerks abgelegt sein können. Das Programmträgermedium 160 kann als computerlesbares Informationsträgermedium ausgebildet sein, beispielsweise als magnetische oder optische Informationsträgerscheibe. Um das CPP in den Computer zu überspielen, wird das Programmträgermedium 160 in ein Eingabegerät 130 des Computers 100 eingeführt, wobei dieses Eingabegerät dazu eingerichtet ist, den Programmcode des CPP von dem Programmträgermedium 160 zu lesen. Der von dem CPP bereitgestellte Programmcode kann von dem Computer 100 allein ausführbar sein, in welchem Fall das Netzwerk 150 und die übrigen Computer 101, 102... entfallen können. Es ist freilich nicht ausgeschlossen, dass es in verteilter Weise von mehreren Recheneinrichtungen des Computersystems ausgeführt wird.

Der von dem CPP repräsentierte Programmcode ist Teil eines CAD-Softwareprogramms, das auf einem Monitor des Computers 100 eine grafische Benutzeroberfläche erzeugt, auf der die beim Konstruieren entstehende Geometrie angezeigt werden kann.

Im Folgenden wird ein beispielhafter Vorgang der Auslagerung von Konstruktionsdaten aus einer bestehenden Produktstruktur erläutert, der in der Programmumgebung der CAD-Software CATIA V5 durchgeführt wird. Eine Funktionalität von CATIA V5 ist die Darstellung eines Strukturbaums auf der grafischen Benutzeroberfläche. Der Strukturbaum (Spezifikationsbaum) protokolliert alle Informationen, die das erzeugte Konstruktionsgebilde definieren. Er beschreibt insbesondere die erzeugte Geometrie jedes Bauteils des Konstruktionsgebildes, die Unterteilung der Geometrie in einzelne Einheiten, die geometrische Manipulation solcher Einheiten sowie die Kombination der Bauteile zu dem Konstruktionsgebilde. Für nähere Erläuterungen zu Aufbau, Funktion und Inhalt von Strukturbäumen in CATIA V5 wird auf die eingangs zitierten Buchveröffentlichungen verwiesen.

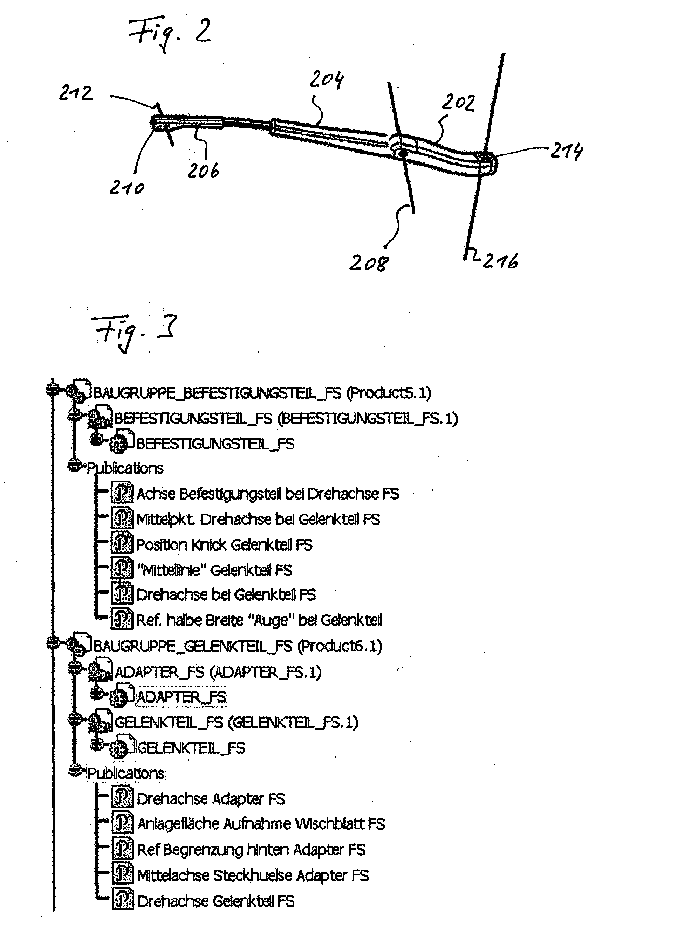

Bevor der beispielhafte Auslagerungsvorgang erläutert wird, sei zunächst auf die zugrundeliegende dreidimensionale geometrische Konstruktion verwiesen, die in Figur 2 gezeigt ist. Das dort gezeigte beispielhafte CAD-Konstruktionsbild stellt einen fahrerseitigen Wischerarm eines Frontscheiben-Wischersystems für ein Automobil dar. Der Wischerarm ist aus drei Bauteilen aufgebaut, die zu einer Baugruppe zusammenfasst sind. Er umfasst ein Befestigungsteil 202, ein Gelenkteil 204 sowie einen Adapter 206. Das Befestigungsteil 202 und das Gelenkteil 204 sind um eine Drehachse 208 gelenkig miteinander verbunden. Diese Drehachse sei hier rein beispielhaft als "Drehachse bei Gelenkteil FS" bezeichnet und findet im Rahmen der weiteren Erläuterung der Figuren noch Verwendung. Eine an dem Adapter 206 ausgebildete Öse 210 ermöglicht eine um eine Drehachse 212 gelenkige Anbringung eines nicht näher dargestellten Wischerblatts an dem Adapter 206. Ferner bildet eine an dem Befestigungsteil 202 ausgebildete Öse 214 eine Anbringungsstelle, an der der Wischerarm um eine Drehachse 216 gelenkig an einem ebenfalls nicht näher dargestellten Hebelarm einer Antriebseinheit des Wischersystems anzubringen ist.

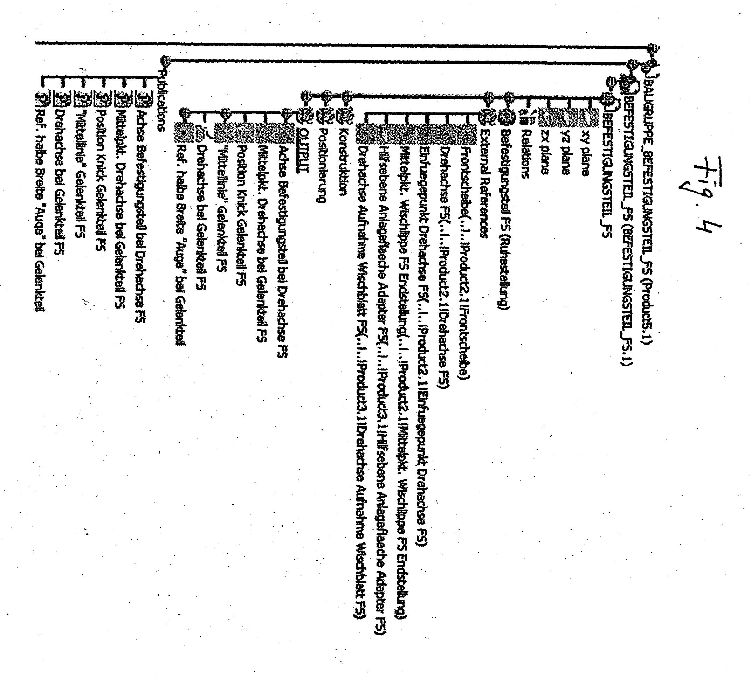

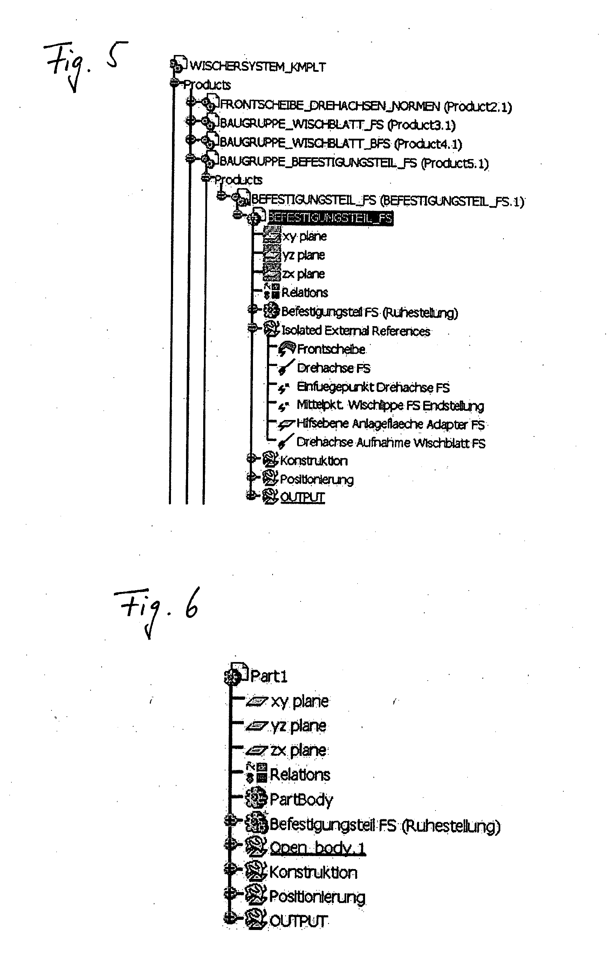

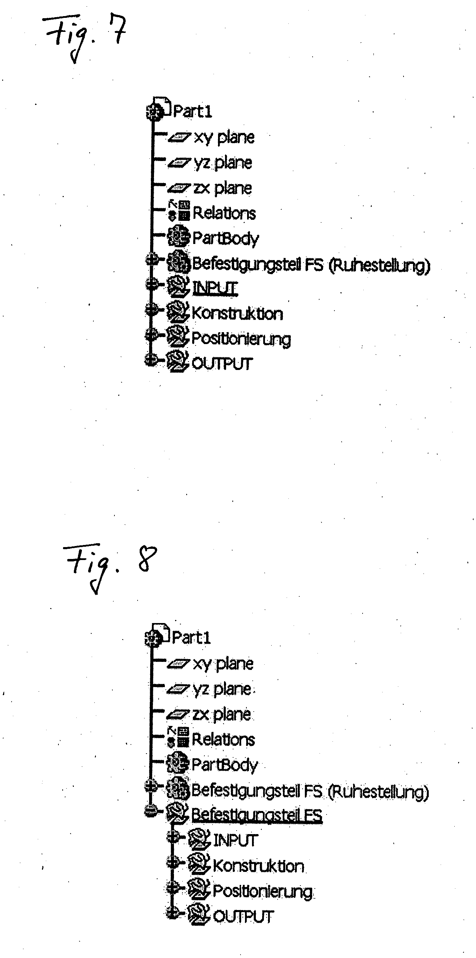

Figur 3 zeigt einen beispielhaften Strukturbaum in CATIA V5 für die Bauteile des in Fig. 2 gezeigten Wischerarms. Man erkennt in dem Strukturbaum einen Eintrag "BEFESTIGUNGSTEIL_FS". Dieser Eintrag weist auf eine vorhandene CATPart-Datei hin, in der die geometrische Information über das Befestigungsteil 202 abgelegt ist. Des weiteren sind CATPart-Dateien "ADAPTER_FS" und "GELENKTEIL_FS" zu erkennen, in denen die geometrische Information über den Adapter 206 bzw. das Gelenkteil 204 abgelegt ist.

Die drei vorstehend genannten CATPart-Dateien sind in der durch den Strukturbaum der Fig. 3 dargestellten Produktstruktur verschiedenen Produktdateien untergeordnet. Speziell ist die Bauteildatei "BEFESTIGUNGSTEIL_FS" einer CATProduct-Datei "BAUGRUPPE_BEFESTIGUNGSTEIL_FS (Product5.1)" untergeordnet. In Letztere ist außerdem ein Ordner *Publications* eingereiht, in dem verschiedene veröffentlichte geometrische Objekte abgelegt sind, deren Wert von dem Befestigungsteil 202 beeinflusst wird. Man erkennt, dass dieser Ordner unter anderem einen Eintrag "Drehachse bei Gelenkteil FS" enthält. Dieser Eintrag deutet auf die Drehachse 208 zwischen dem Befestigungsteil 202 und dem Gelenkteil 204 hin. Die Veröffentlichung dieser Drehachse ermöglicht es allen in der Produktstruktur darunterliegenden Komponenten, die Drehachse 202, d.h. deren aktuellen Wert, zu importieren.

Die Bauteildateien "ADAPTER_FS" und "GELENKTEIL_FS" dagegen sind einer gemeinsamen CATProduct-Datei "BAUGRUPPE_GELENKTEIL_FS (Product6.1)" untergeordnet. In diese gemeinsame übergeordnete Produktdatei ist ebenfalls ein Ordner *Publications* eingereiht, in dem verschiedene veröffentlichte geometrische Objekte abgelegt sind, deren Wert von dem Gelenkteil 204 und/oder dem Adapter 206 bestimmt wird.

In dem Spezifikationsbaum der Fig. 3 ist über jeder CATPart-Datei ein Knoten eingefügt, der einen sogenannten Instance-Namen angibt. Dieser protokolliert die im aktiven Dokument verwendete Anzahl der jeweils darunterliegenden CATPart-Datei.

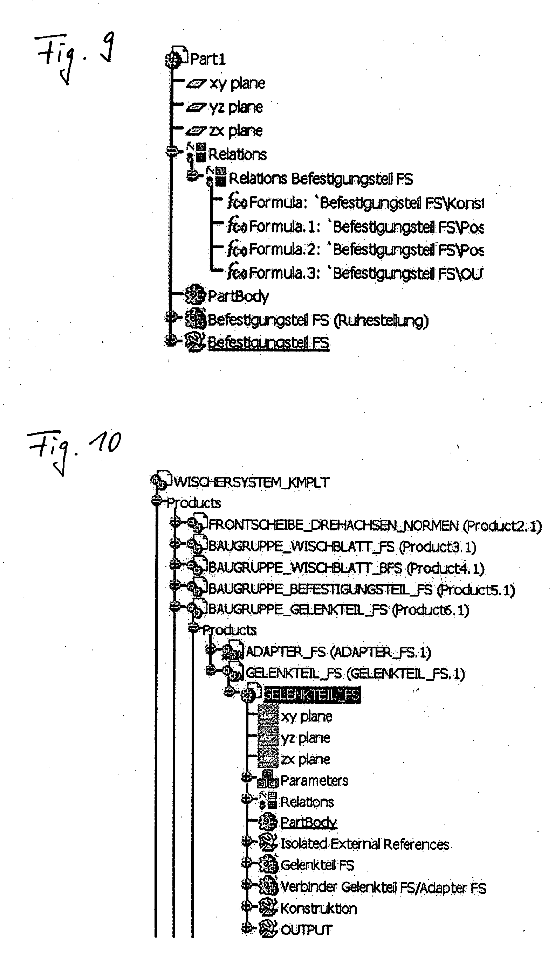

Fig. 4 zeigt den der Produktdatei "BAUGRUPPE_BEFESTIGUNGSTEIL_FS (Product5.1)" zugehörigen Teil des Strukturbaums, wobei der Knoten "BEFESTIGUNGSTEIL_FS" geöffnet ist, d.h. die verschiedenen Ordner der Bauteildatei "BEFESTIGUNGSTEIL_FS" im einzelnen dargestellt sind. Man erkennt anhand des Ordners *External References*, dass die Bauteildatei "BEFESTIGUNGSTEIL_FS" verschiedene geometrische Objekte importiert. Ein Beispiel eines importierten geometrischen Objekts ist "Drehachse FS". Diese Achse entspricht der Drehachse 216 in Fig. 2. Der in Klammern gefasste Ausdruck hinter "Drehachse FS", nämlich "(..!..!Product2.1!DrehachseFS)", gibt die Quelle (Datei) an, von der die Bauteildatei "BEFESTIGUNGSTEIL_FS" den aktuellen Wert der Drehachse 216 bezieht. Wenngleich in den Figuren nicht näher dargestellt, ist das geometrische Objekt "Drehachse FS", wie auch die anderen importierten Objekte, an höherer Stelle in der Produktstruktur definiert und veröffentlicht. Importierte Objekte können auch als globale Eingangsvariablen des betreffenden Bauteils betrachtet werden.

Ein Körper *Befestigungsteil FS (Ruhestellung)* in Fig. 4 enthält die körperbildende Geometrieinformation des Befestigungsteils 202. Im Rahmen der Erfindung kann dieser Körper als eine Datenschachtel eines ersten Typs angesehen werden. Der Ordner *External References* dagegen ist ein sogenannter offener Körper, der als eine Datenschachtel eines zweiten Typs betrachtet werden kann. Die Bauteildatei "BEFESTIGUNGSTEIL_FS" enthält in dem hier betrachteten Beispielfall weitere offene Körper, nämlich *Konstruktion, Positionierung* und *OUTPUT*, die vom Benutzer eingerichtet wurden. Die offenen Körper *Konstruktion* und *Positionierung* können beispielsweise draht- oder flächenhafte (nicht-körperbildende) Geometrieinformation enthalten, die für die Konstruktion des Befestigungsteils 202 wichtig ist. Der Ordner *OUTPUT* enthält die gleichen geometrischen Objekte, die im Ordner *Publications* in der Produktdatei "BAUGRUPPE_BEFESTIGUNGSTEIL_FS (Product5.1)" veröffentlicht sind. Da ihr Wert vom Befestigungsteil 202 bestimmt wird, können sie als lokale Ausgangsvariablen des Befestigungsteils 202 betrachtet werden.

Festzuhalten ist also, dass bei dem betrachteten Beispielfall die Ausgangsvariablen des Befestigungsbauteils 202 (auch) unmittelbar in der zugehörigen CATPart-Datei dieses Bauteils enthalten sind, nämlich in einem gesonderten offenen Körper. Dieser ist zudem geeignet bezeichnet (hier mit dem Namen "OUTPUT"), so dass ein Nutzer die Bedeutung des Inhalts dieses Ordners ohne weiteres erkennen kann. Es empfiehlt sich im Rahmen der Erfindung, für jedes Bauteil etwaige Ausgangsvariablen in einer eigenen Datenschachtel, insbesondere einem offenen Körper, der zugehörigen Bauteildatei abzulegen, selbst wenn diese Ausgangsvariablen schon außerhalb der betreffenden Bauteildatei veröffentlicht sind.

Die Bauteildatei "BEFESTIGUNGSTEIL_FS" enthält ferner noch einen Ordner *Relations*, in dem Formeln und sonstige Beziehungen abgelegt sein können, die das Zusammenspiel zwischen den verschiedenen Elementen (Grundkörper, Punkte, Linien, Flächen) des Befestigungsteils 202 regeln. Der Ordner *Relations* kann als eine Datenschachtel eines dritten Typs betrachtet werden.

Es soll nun angenommen werden, dass ein Benutzer die Konstruktionsdaten des Bauteils 202 auslagern und die ausgelagerten Daten in eine neu erstellte CATPart-Datei einfügen will. Sofern er nicht mit allen Einzelheiten des Befestigungsteils 202 und der zugehörigen Bauteildatei "BEFESTIGUNGSTEIL_FS" vertraut ist, prüft er zunächst, ob das Befestigungsteil 202 geometrisch von einer oder mehr Eingangsvariablen abhängt. Für geometrische Objekte als Eingangsvariablen (also Punkte, Linien, Flächen) prüft er hierzu, ob ein Ordner *External References* in der Bauteildatei "BEFESTIGUNGSTEIL_FS" vorhanden ist. Im vorliegenden Beispielfall ist in der Bauteildatei "BEFESTIGUNGSTEIL_FS" tatsächlich ein solcher Ordner angelegt.

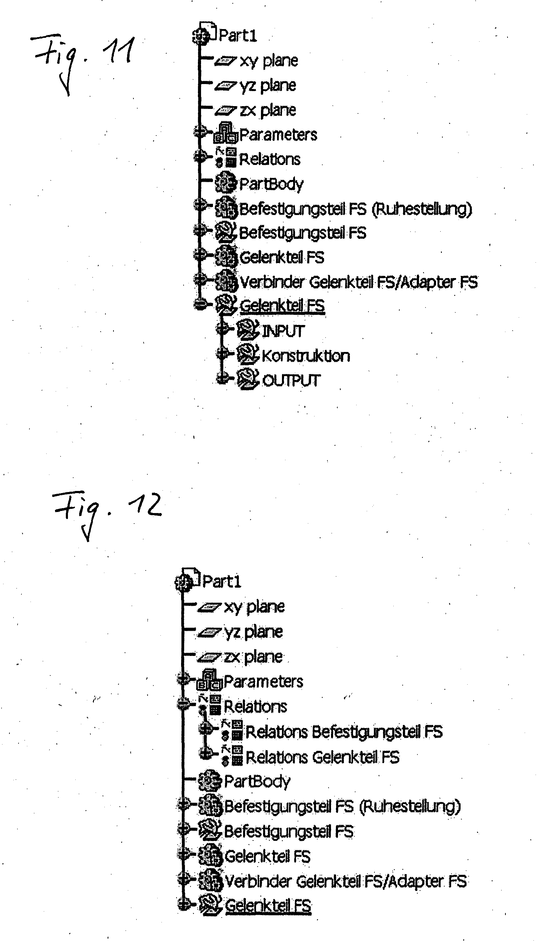

Anschließend bewirkt der Benutzer eine Isolierung der importierten Variablen des Befestigungsteils 202. Für die Einträge in dem Ordner *External References* der Bauteildatei "BEFESTIGUNGSTEIL_FS" kann er hierbei so vorgehen, dass er diese Einträge selektiert (markiert) und im Kontextmenü von CATIA V5 einen Befehl *Selected objects > Isolate* wählt. Als Folge der Isolierung der importierten Verweise nimmt CATIA V5 eine Umbenennung des Ordners *External References* in *Isolated External References* vor. Der Strukturbaum der Figur 5 zeigt den Zustand der Bauteildatei "BEFESTIGUNGSTEIL_FS" nach der Isolierung der Eingangsvariablen des Befestigungsteils 202.

Die dateiübergreifenden Verknüpfungen der Bauteildatei "BEFESTIGUNGSTEIL_FS" mit der oder den Quelldateien der Eingangsvariablen des Befestigungsteils 202 sind durch die Isolierung der Eingangsvariablen getrennt. Es kann nun der Inhalt der Bauteildatei "BEFESTIGUNGSTEIL_FS" kopiert und in die angesprochene neue Bauteildatei überführt werden. Hierzu genügt es für den Benutzer, alle Ordner der Bauteildatei "BEFESTIGUNGSTEIL_FS", in der beschreibende Informationen für das Befestigungsteil 202 enthalten sind, zu selektieren und die selektierten Ordner beispielsweise mit einem Befehl *Copy* zu duplizieren. Im vorliegenden Beispielfall sind die zu selektierenden und zu kopierenden Ordner der Bauteildatei "BEFESTIGUNGSTEIL_FS" der Körper *Befestigungsteil FS (Ruhestellung)*, die offenen Körper *Isolated External References, Konstruktion, Positionierung* und *OUTPUT* sowie der Ordner *Relations*.

Die kopierten Dateiinhalte der Bauteildatei "BEFESTIGUNGSTEIL_FS" fügt der Benutzer dann in die neue Bauteildatei ein, beispielsweise mit einem Befehl *Paste*. Fig. 6 zeigt einen Strukturbaum für die neue Bauteildatei nach Einfügung der kopierten Dateiinhalte aus der Bauteildatei "BEFESTIGUNGSTEIL_FS". Die neue Datei, bezeichnet mit dem Namen "Part1", enthält mehrere Ordner, die den kopierten Ordnern der Bauteildatei "BEFESTIGUNGSTEIL_FS" entsprechen. Speziell enthält die Bauteildatei "Part1" einen Körper *Befestigungsteil FS (Ruhestellung)*, dessen Inhalt demjenigen aus dem gleichnamigen Körper der Bauteildatei "BEFESTIGUNGSTEIL_FS" entspricht. Ferner enthält die Bauteildatei "Part1" einen Ordner *Relations,* in dem alle Beziehungen abgelegt sind, die auch in dem gleichnamigen Ordner der Bauteildatei "BEFESTIGUNGSTEIL_FS" enthalten sind. Außerdem enthält die Bauteildatei "Part1" noch vier offene Körper *Open body.1, Konstruktion, Positionierung* und *OUTPUT*. Die drei letzteren dieser offenen Körper enthalten die gleichen Informationen wie die gleichnamigen Datenschachteln der Bauteildatei "BEFESTIGUNGSTEIL_FS". Die kopierten Informationen über die Eingangsvariablen des Befestigungsteils 202 sind dagegen in dem ersten dieser offenen Körper abgelegt, nämlich in *Open Body.1*. Für diesen offenen Körper übernimmt CATIA V5 nicht den Namen des Ursprungsordners in der Bauteildatei "BEFESTIGUNGSTEIL_FS", sondern gibt ihm zunächst einen Default-Namensbestandteil, hier "Open body". Um den Inhalt des betreffenden Ordners in der Bauteildatei "Part1" leichter identifizieren zu können, nimmt der Benutzer anschließend eine Umbenennung des offenen Körpers *Open body.1* vor. Im Beispielfall weist er ihm den Namen "INPUT" zu (siehe Figur 7).

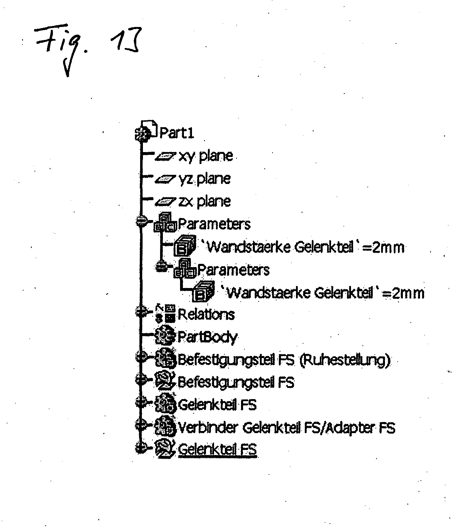

Des weiteren bewirkt der Benutzer eine Einordnung aller mit Information gefüllten offenen Körper in der Bauteildatei "Part1" unter einen übergeordneten weiteren offenen Körper, den er zu diesem Zweck eigens erzeugt. Diese Unterordnung schafft eine hohe Übersichtlichkeit in der Bauteildatei "Part1". Den übergeordneten weiteren offenen Körper benennt der Benutzer zweckmäßigerweise mit einem Namen, der auf das betreffende Bauteil hinweist, auf das sich die untergeordneten offenen Körper beziehen. Im Beispielfall benennt der Benutzer den übergeordneten offenen Körper mit "Befestigungsteil FS" (siehe Figur 8). Diese hierarchische, strukturierte Einordnung der Daten in die Bauteildatei "Part1" ist insbesondere für den Fall sinnvoll und günstig, dass die Konstruktionsdaten von zwei oder mehr Bauteilen in eine gemeinsame Auslagerungsdatei eingefügt werden sollen.

Eine ähnliche hierarchische Unterordnung nimmt der Benutzer auch noch an den in dem Ordner *Relations* in der Bauteildatei "Part1" abgelegten Beziehungen des Befestigungsteils 202 vor. Er bewirkt hierzu die Erzeugung eines Unterordners in dem Ordner *Relations,* benennt diesen Unterordner geeignet, so dass er einen auf das Befestigungsteil 202 hinweisenden Namensbestandteil enthält, und ordnet alle Beziehungen, die zu dem Befestigungsteil 202 gehören, in den Unterordner ein. Figur 9 zeigt ein beispielhaftes Ergebnis dieser Operationen. Der Ordner *Relations* enthält nun einen Unterordner *Relations Befestigungsteil FS*, der wiederum verschiedene Formeln enthält, die aus dem Ordner *Relations* der Bauteildatei "BEFESTIGUNGSTEIL_FS" stammen.

Es sei nun angenommen, dass der Benutzer, nachdem er in vorstehend erläuterter Weise die Konstruktionsdaten des Befestigungsteils 202 in die Bauteildatei "Part1" ausgelagert hat, auch noch die Konstruktionsdaten des Gelenkteils 204 in dieselbe Datei auslagern will. In dem Strukturbaum der Figur 10 ist zu erkennen, dass die Bauteildatei "Gelenkteil FS" einen Körper *Gelenkteil FS* und einen Körper *Verbinder Gelenkteil FS*/*Adapter FS* enthält. Ferner enthält sie offene Körper *Isolated External References* (hervorgegangen in analoger Weise wie zuvor beschrieben durch Isolierung von importierten Eingangsvariablen des Gelenkteils 204, die vorher in einem offenen Körper *External References* der Bauteildatei "Gelenkteil FS" enthalten waren), *Konstruktion* und *OUTPUT*. Der offene Körper *OUTPUT* der Bauteildatei "Gelenkteil FS" enthält beispielsweise alle oder nur einen Teil der veröffentlichten Elemente aus der CATProduct-Datei "BAUGRUPPE_GELENKTEIL_FS (Product6.1)" (siehe Fig. 3). Außerdem enthält die Bauteildatei "Gelenkteil FS" einen Ordner *Relations* und einen Ordner *Parameter*. In Letzterem können lokal verwendete Parameter des Gelenkteils 204, wie z.B. eine Wandstärke, abgelegt sein. Der Ordner *Parameter* kann hier als Datenschachtel eines vierten Typs betrachtet werden.

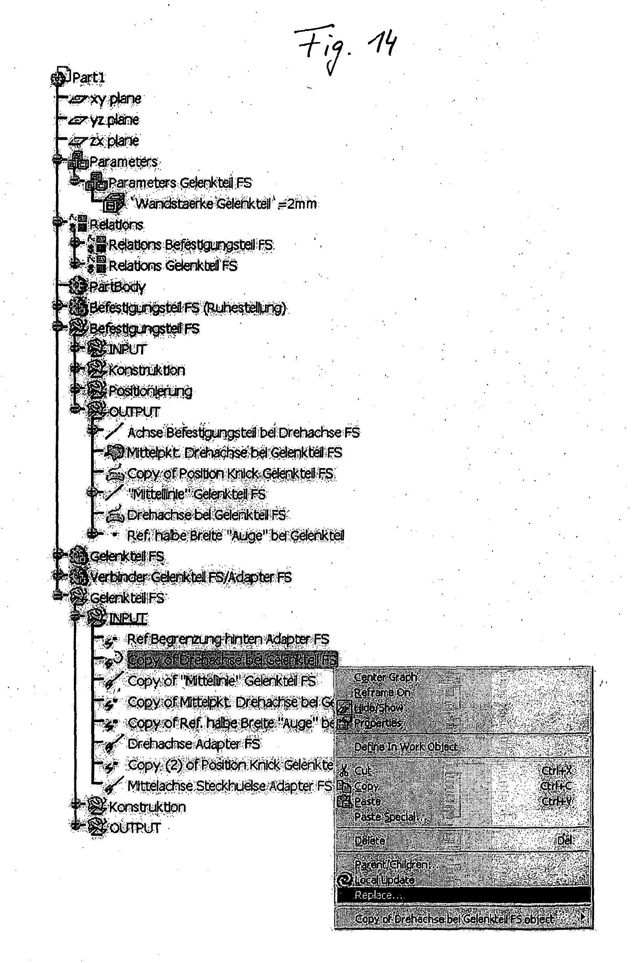

Die Auslagerung der Konstruktionsdaten des Gelenkteils 204 erfolgt in analoger Weise wie im Zusammenhang mit dem Befestigungsteil 202 beschrieben. Figur 11 zeigt einen Strukturbaum für die Bauteildatei "Part1", nachdem die Ordner *Relations, Parameter, Gelenkteil FS, Verbinder Gelenkteil FS*/*Adapter FS, Isolated External References, Konstruktion* und *OUTPUT* der Bauteildatei "Gelenkteil FS" kopiert und in die Bauteildatei "Part1" eingefügt wurden, nachdem außerdem der die Eingangsvariablen des Gelenkteils 204 enthaltende offene Körper der Bauteildatei "Part1" in "INPUT" umbenannt wurde und nachdem alle dem Gelenkteil 204 zugeordneten offenen Körper in der Bauteildatei "Part1" unter einen weiteren, übergeordneten Körper *Gelenkteil FS* eingeordnet wurden.

Fig. 12 zeigt einen Zustand des Strukturbaums der Bauteildatei "Part1", in dem der Ordner *Relations* einen weiteren Unterordner *Relations Gelenkteil FS* enthält, der dem Unterordner *Relations Befestigungsteil FS* nebengeordnet ist. Dieser weitere Unterordner *Relations Gelenkteil FS* enthält alle Formelbeziehungen des Gelenkteils 204, die aus dem Ordner *Relations* der Bauteildatei "Gelenkteil FS" kopiert wurden.

In der Bauteildatei "Part1" werden zweckmäßigerweise nicht nur Formelbeziehungen sondern auch Parameter nach Bauteilnamen geordnet. Deshalb nimmt der Benutzer in dem betrachteten Beispielfall auch eine Unterteilung des Ordners *Parameters* in der Bauteildatei "Part1" vor, so dass jederzeit erkennbar ist, welchem Bauteil ein in diesen Ordner einsortierter Parameter zugehörig ist. Bei dem in Fig. 13 gezeigten Strukturbaum für die Bauteildatei "Part1" ist hierzu in dem Ordner *Parametersein* Unterordner *Parameters Gelenkteil FS* eingerichtet, der einen auf das betreffende Bauteil (das Gelenkteil 204) hinweisenden Namensbestandteil hat, nämlich "Gelenkteil FS". Der Unterordner *Parameters Gelenkteil FS* enthält alle Parameter, die aus dem Ordner *Parameters* der Bauteildatei "Gelenkteil FS" kopiert wurden. Im Beispielfall ist dies ein einziger Parameter mit dem Namen "Wandstärke Gelenkteil".

Mit der soweit anhand der Strukturbäume der Figuren 3 bis 13 vorgestellten Methodik können die Konstruktionsdaten mehrerer Bauteile in eine gemeinsame Ziel-Bauteildatei ausgelagert werden, und zwar so, dass die in die Zieldatei ausgelagerten Daten sowohl Informationen über Eingangsvariablen jedes Bauteils (Ordner *INPUT*) als auch Informationen über Ausgangsvariablen jedes Bauteils (Ordner *OUTPUT*) enthalten können. Dies kann vorteilhaft ausgenutzt werden, wenn geometrisch voneinander abhängige, assoziativ verknüpfte Bauteile in eine gemeinsame Zieldatei ausgelagert werden. Das Vorhandensein solcher Informationen über etwaige Eingangs- und Ausgangsvariablen der Bauteile in der Zieldatei erlaubt es, dateiintern in der Zieldatei eine Verknüpfung zwischen einer Eingangsvariable eines Bauteils und einer Ausgangsvariable eines anderen Bauteils herzustellen und so auch in der Zieldatei die Assoziativität der Bauteile widerzuspiegeln.

In dem betrachteten Beispielfall der Fig. 2 ist das Gelenkteil 204 geometrisch von dem Befestigungsteil 202 abhängig. Es benötigt als Eingangsvariable einen Wert der Drehachse 208. In der Zieldatei "Part1", in die die Konstruktionsdaten beider Bauteile ausgelagert wurden, enthält der Unterordner *OUTPUT* des offenen Körpers *Befestigungsteil FS* einen Eintrag "Drehachse bei Gelenkteil FS". Wie bereits gesagt, handelt es sich dabei um die Drehachse 208. In ähnlicher Weise enthält in der Bauteildatei "Part1" der Unterordner *INPUT* des offenen Körpers *Gelenkteil FS* einen diese Drehachse bezeichnenden Eintrag, wenn die Ursprungsdatei, aus der die Daten über das Gelenkteil 204 bezogen werden (also die Bauteildatei "Gelenkteil FS") einen entsprechenden Eintrag in ihrem Order *External References* aufweist. Der Strukturbaum der Fig. 14 zeigt diese Situation, wobei der entsprechende Eintrag im Unterordner *INPUT* des offenen Körpers *Gelenkteil FS* "Copy of Drehachse bei Gelenkteil FS" lautet ("Copy of" wird von CATIA V5 automatisch erzeugt, um innerhalb einer Bauteildatei denselben Namen nicht mehrfach zu verwenden). Dieser Eintrag kann jedoch jederzeit vom Benutzer in " Drehachse bei Gelenkteil FS" geändert werden.

Um geometrische Abhängigkeiten der verschiedenen Bauteile aufzufinden, deren Daten in eine gemeinsame Zieldatei ausgelagert wurden, müssen danach lediglich die verschiedenen *INPUT-* und *OUTPUT*-Ordner der Zieldatei (oder vergleichbar benannte Ordner) auf Übereinstimmungen untersucht werden. Dies kann im einfachsten Fall beispielsweise durch Überprüfung auf gleiche Namen oder zumindest gleiche Namensbestandteile erfolgen. Wird eine solche Übereinstimmung gefunden, kann durch eine Operation, bei der die Eingangsvariable eines ersten Bauteils durch die als übereinstimmend gefundene Ausgangsvariable eines zweiten Bauteils ersetzt wird, eine Verknüpfung innerhalb der Zieldatei zwischen den beiden Bauteilen hergestellt werden. Nimmt danach der Konstrukteur Änderungen an der Geometrie des zweiten Bauteils vor, die sich in einem geänderten Wert der betreffenden Ausgangsvariable niederschlagen, so machen sich diese Änderungen assoziativ in dem ersten Bauteil bemerkbar, das auf den Wert dieser Ausgangsvariable zugreift. Auf diese Weise kann in derselben Bauteildatei assoziativ mit mehreren Bauteilen gearbeitet werden.

In dem Strukturbaum der Fig. 14 beispielsweise findet der Benutzer, dass der Eintrag "Drehachse bei Gelenkteil FS" im Unterordner *OUTPUT* des offenen Körper *Befestigungsteil FS* und der Eintrag " Copy of Drehachse bei Gelenkteil FS" im Unterordner *INPUT* des offenen Körpers *Gelenkteil FS* dieselbe Variable betreffen. Durch Selektieren des letzteren Eintrags und Ausführen eines Befehls *Replace* (wie in Fig. 14 durch einen Ausschnitt aus einem Kontextmenü dargestellt) kann der Benutzer die beiden Einträge miteinander verknüpfen.

Es versteht sich, dass die vorstehend anhand eines Beispielfalls erläuterte Vorgehensweise auch unter Steuerung eines Softwareprogramms automatisiert ablaufen kann. Insbesondere die strukturierte Einordnung der ausgelagerten Daten in die Zieldatei und die Prüfung auf Übereinstimmungen zwischen Ein- und Ausgangsvariablen in der Zieldatei kann von einem solchen Softwareprogramm automatisch durchgeführt werden.

Eine Rückführung ausgelagerter Daten in die jeweilige Ursprungsdatei oder/und in die ursprüngliche Produktstruktur oder/und in eine neue Produktstruktur ist in analoger Weise möglich, wobei hierzu die oben beschriebene Vorgehensweise im wesentlichen nur in umgekehrter Richtung durchzuführen ist.

## Patentansprüche

1. Computerimplementiertes System zum Auslagern von Konstruktionsdaten aus einer mit einem Softwareprogramm zum computergestützten Konstruieren erstellten ersten Bauteildatei, wobei das Softwareprogramm Bauteildateien und Produktdateien unterstützt, wobei Bauteildateien zur Ablage von Informationen über die Geometrie einzelner Bauteile dienen und Produktdateien zur Ablage von Informationen über das Zusammenspiel mehrerer zu einer Baugruppe zusammengefasster Bauteile oder/und Unterbaugruppen dienen, wobei die Konstruktionsdaten ein erstes Bauteil (202) eines zumindest dieses erste Bauteil umfassenden Konstruktionsgebildes (202, 204, 206) repräsentieren, wobei das System dazu ausgebildet ist, in Antwort auf ein durch eine benutzerseitige Eingabeoperation erzeugtes Steuersignal die folgenden Schritte programmgesteuert durchzuführen:
- Prüfen, ob das erste Bauteil geometrisch von mindestens einer Eingangsvariable abhängt, deren Wert die erste Bauteildatei durch dateiübergreifende Verknüpfung von einer Quelldatei bezieht,
- falls bei der Prüfung festgestellt wird, dass das erste Bauteil von mindestens einer Eingangsvariable abhängt, Aufheben der Verknüpfung der ersten Bauteildatei mit der Quelldatei jeder Eingangsvariable des ersten Bauteils,
- Duplizieren von das erste Bauteil beschreibenden Dateiinhalten der ersten Bauteildatei und Einfügen der duplizierten Dateiinhalte in eine zweite Bauteildatei.

2. Verfahren zum Auslagern von Konstruktionsdaten aus einer mit einem Softwareprogramm zum computergestützten Konstruieren erstellten ersten Bauteildatei, wobei das Softwareprogramm Bauteildateien und Produktdateien unterstützt, wobei Bauteildateien zur Ablage von Informationen über die Geometrie einzelner Bauteile dienen und Produktdateien zur Ablage von Informationen über das Zusammenspiel mehrerer zu einer Baugruppe zusammengefasster Bauteile oder/und Unterbaugruppen dienen, wobei die Konstruktionsdaten ein erstes Bauteil (202) eines zumindest dieses erste Bauteil umfassenden Konstruktionsgebildes (202, 204, 206) repräsentieren, wobei das Verfahren die Schritte umfasst:
- Prüfen, ob das erste Bauteil geometrisch von mindestens einer Eingangsvariable abhängt, deren Wert die erste Bauteildatei durch dateiübergreifende Verknüpfung von einer Quelldatei bezieht,
- falls bei der Prüfung festgestellt wird, dass das erste Bauteil von mindestens einer Eingangsvariable abhängt, Aufheben der Verknüpfung der ersten Bauteildatei mit der Quelldatei jeder Eingangsvariable des ersten Bauteils,
- Duplizieren von das erste Bauteil beschreibenden Dateiinhalten der ersten Bauteildatei und Einfügen der duplizierten Dateiinhalte in eine zweite Bauteildatei.

3. Verfahren nach Anspruch 2,
wobei das Softwareprogramm in Bauteildateien die Einrichtung von Datenschachteln eines ersten Typs, welche der Ablage körperbildender Geometrieinformation des betreffenden Bauteils dienen, und Datenschachteln eines zweiten Typs unterstützt, welche der Ablage nicht-körperbildender Geometrieinformation des Bauteils dienen,
**dadurch gekennzeichnet, dass** der aus jeder Datenschachtel des ersten oder zweiten Typs der ersten Bauteildatei entnommene Inhalt in der zweiten Bauteildatei in eine entsprechende Datenschachtel des ersten bzw. zweiten Typs eingeordnet wird.

4. Verfahren nach Anspruch 3,
wobei die Eingangsvariable ein geometrisches Objekt ist, beispielsweise ein Punkt, eine Linie oder eine Fläche, wobei weiter das Softwareprogramm dazu eingerichtet ist, in einer Bauteildatei jedes geometrische Eingangsobjekt in einer gemeinsamen, für derartige geometrische Eingangsobjekte reservierten Datenschachtel des zweiten Typs abzulegen und diese reservierte Datenschachtel des zweiten Typs mit einem vorbestimmten reservierten Namen zu benennen, und wobei das Softwareprogramm dazu eingerichtet ist, benutzerseitig neu eingerichtete Datenschachteln des zweiten Typs standardmäßig mit einem einheitlichen Namensbestandteil zu versehen, **gekennzeichnet durch** das Benennen derjenigen Datenschachtel des zweiten Typs der zweiten Bauteildatei, in die jedes geometrische Eingangsobjekt des ersten Bauteils eingeordnet wird, mit einem den standardmäßig vorgegebenen Namensbestandteil nicht enthaltenden Namen.

5. Verfahren nach Anspruch 3 oder 4,
ferner **gekennzeichnet durch** das Erzeugen einer weiteren Datenschachtel des zweiten Typs in der zweiten Bauteildatei, das Unterordnen jeder Datenschachtel des zweiten Typs, in der Inhalt aus der ersten Bauteildatei abgelegt wird, unter diese weitere Datenschachtel des zweiten Typs, sowie das Benennen der weiteren Datenschachtel des zweiten Typs mit einem auf das erste Bauteil hinweisenden Namen.

6. Verfahren nach einem der Ansprüche 2 bis 5,
wobei das Softwareprogramm in Bauteildateien die Einrichtung von Datenschachteln eines dritten Typs, welche der Ablage von Beziehungen dienen, oder/und Datenschachteln eines vierten Typs unterstützt, welche der Ablage von Parametern dienen,
**dadurch gekennzeichnet, dass** der aus jeder Datenschachtel des dritten oder vierten Typs der ersten Bauteildatei entnommene Inhalt in der zweiten Bauteildatei so in eine entsprechende Datenschachtel des dritten bzw. vierten Typs eingeordnet wird, dass sich der betreffende Inhalt in einer Datenschachtel des dritten bzw. vierten Typs der zweiten Bauteildatei befindet, welche einer weiteren Datenschachtel des dritten bzw. vierten Typs der zweiten Bauteildatei untergeordnet ist, und dass die untergeordnete Datenschachtel des dritten bzw. vierten Typs der zweiten Bauteildatei mit einem einen Hinweis auf das erste Bauteil enthaltenden Namen benannt wird.

7. Verfahren nach einem der Ansprüche 2 bis 6,
wobei die zweite Bauteildatei bereits Dateiinhalte enthält, welche mindestens ein weiteres Bauteil beschreiben, **dadurch gekennzeichnet, dass** die duplizierten Dateiinhalte der ersten Bauteildatei in Datenschachteln der zweiten Bauteildatei eingeordnet werden, welche nebengeordnet zu Datenschachteln sind, in denen die das mindestens eine weitere Bauteil beschreibenden Dateiinhalte enthalten sind.

8. Verfahren nach einem der Ansprüche 2 bis 7,
**dadurch gekennzeichnet, dass** für den Fall, dass das erste Bauteil von einer oder mehr Eingangsvariablen abhängt und nach Einfügung der duplizierten Dateiinhalte der ersten Bauteildatei in die zweite Bauteildatei diese außerdem Informationen über eine oder mehr Ausgangsvariablen eines weiteren Bauteils enthält, der Inhalt der zweiten Bauteildatei daraufhin untersucht wird, ob eine Eingangsvariable des ersten Bauteils einer Ausgangsvariable des weiteren Bauteils entspricht, und dass bei Feststellung einer Übereinstimmung zwischen einer Eingangsvariable des ersten Bauteils und einer Ausgangsvariable des weiteren Bauteils die betreffende Ausgangsvariable mit der betreffenden Eingangsvariable innerhalb der zweiten Bauteildatei verknüpft wird.

9. Computerprogrammprodukt, das einen Programmcode verkörpert, welcher dazu ausgelegt ist, bei Ausführung auf einem Computer in Antwort auf eine oder mehrere benutzerseitige Eingabeoperationen gewünschtenfalls interaktiv die Durchführung des Verfahrens nach einem der Ansprüche 2 bis 8 zu bewirken.

10. Computerlesbares Informationsträgermedium, auf dem ein Computerprogrammprodukt nach Anspruch 9 gespeichert ist.
